# EUROPÄISCHE PATENTSCHRIFT

(11) **EP 2 851 911 B1**
(45) Veröffentlichungstag und Bekanntmachung des Hinweises auf die Patenterteilung: **17.04.2019**
(21) Anmeldenummer: 14182088.6
(22) Anmeldetag: 25.08.2014
(51) Int. Cl.: H01F 13/00, H05K 9/00

(54) **Beseitigung von anhysteretischem Magnetismus in ferromagnetischen Körpern**
Removal of anhysteretic magnetism in ferromagnetic bodies
Élimination du magnétisme anhystérétique dans des corps ferromagnétiques

(30) Priorität: 06.09.2013 CH 15312013
(43) Veröffentlichungstag der Anmeldung: 25.03.2015
(73) Patentinhaber: Maurer, Albert, 8624 Grüt (CH)
(72) Erfinder: Maurer, Albert, 8624 Grüt (CH); Meyer, Urs, 8172 Niederglatt (CH)
(74) Vertreter: Schneider Feldmann AG Patent- und Markenanwälte

(56) Entgegenhaltungen:
- EP-A1- 0 686 984
- EP-A1- 1 693 833
- EP-A1- 1 791 138
- EP-A2- 1 693 883
- WO-A2-01/20621
- US-A- 2 848 660
- Chapter 3: "EMI Shielding Enclosure and Access" In: Xingcun Colin Tong: "Advanced Materials and Design for Electromagnetic Interference Shielding", 19. November 2008 (2008-11-19), CRC Press, XP002735330, ISBN: 978-1-4200-7358-4 Seiten 67-87, DOI: 10.1201/9781420073591.ch3, * Seite 68, Zeile 5 - Zeile 9 * * Seite 75, Zeile 18 - Zeile 22 * * Seite 78, Zeile 17 - Zeile 18 *

## Beschreibung

### Technisches Gebiet

Die vorliegende Erfindung beschreibt eine Verwendung einer Kammer mit Wänden aus magnetisch hochpermeablem ferromagnetischen Material zur Abschirmung von äusseren Störfeldern, umfassend das Erdmagnetfeld, zur Erreichung eines störfeldfreien Kammerinnenraumes mit einer Reduktion der Störfeldstärke im Kammerinnenraum auf weniger als die Hälfte der Störfeldstärke ausserhalb des Kammerinnenraumes.

### Stand der Technik

Entmagnetisierende Verfahren haben zum Ziel, den in einem Bauteil oder einer Baugruppe befindlichen Restmagnetismus so weit zu beseitigen, dass er bei nachfolgenden Bearbeitungsvorgängen oder in der späteren Nutzung nicht störend in Erscheinung tritt.

Ein vollständiges Entmagnetisieren von ferromagnetischen Körpern wird durch eine thermische Behandlung mit Temperaturen erreicht, welche zu einer Umwandlung des Gefüges führen. Eine solche Behandlung ist bei Halb- oder Fertigfabrikaten in der Regel schädigend und somit nicht zulässig.

Das Entmagnetisieren wird deshalb vornehmlich bei Raumtemperatur durch ein magnetisches Feld bewerkstelligt, das in wechselnder Polarität und mit abnehmender Stärke das zu entmagnetisierende Objekt durchflutet. Diese mit magnetischen Feldern arbeitenden Verfahren sind aber bisher nicht in der Lage, ein dem thermischen Verfahren völlig gleichwertiges Ergebnis zu erzielen.

Die vorliegende Erfindung betrifft ein verbessertes magnetisches Verfahren, das einen geringeren Restmagnetismus erreicht als die bisher bekannten Einrichtungen und Verfahren dieser Art.

Ziel jedes entmagnetisierenden Verfahrens ist ein Endzustand des Materials, der innerhalb der sogenannten Hystereseschlaufe möglichst nahe beim Nullwert von Remanenz bzw. Koerzitivfeldstärke liegt. Magnetische Zustände innerhalb der Hystereseschlaufe werden als anhysteretisch bezeichnet. Grundlagen zu den magnetischen Eigenschaften von ferromagnetischen Materialien sind dem Buch "Magnetismus" von Dr. Karl-Walter Stemme zu entnehmen, erschienen 2004 im Verlag maxon academy, Sachseln, ISBN 3-9520143-3-8. Eine wissenschaftliche Darstellung anhysteretischer Materialzustände mit den zugehörigen Modellen zur Herleitung und Berechnung ist in der Doktorarbeit von Jeremy Walker, University of South Florida, 2007, unter dem Titel "Measurement and modeling of the anhysteretic magnetization of magnetic cores for temperature and frequency dependent effects" veröffentlicht.

Die Messung von Durchflutung und Flussdichte in ferromagnetischem Material ist nur an der Oberfläche eines bestimmten Körpers möglich, weil jeder eingebrachte Sensor dessen inneres Magnetfeld stören würde. Insbesondere sind die Zustände beim Aufmagnetisieren (sogenannte Neukurve) und beim Entmagnetisieren (sogenannte Kommutierungskurve), somit das Materialverhalten im anhysteretischen Bereich, nur mit äusserlich angebrachten Mitteln und nur für einen homogenen Körper bestimmbar.

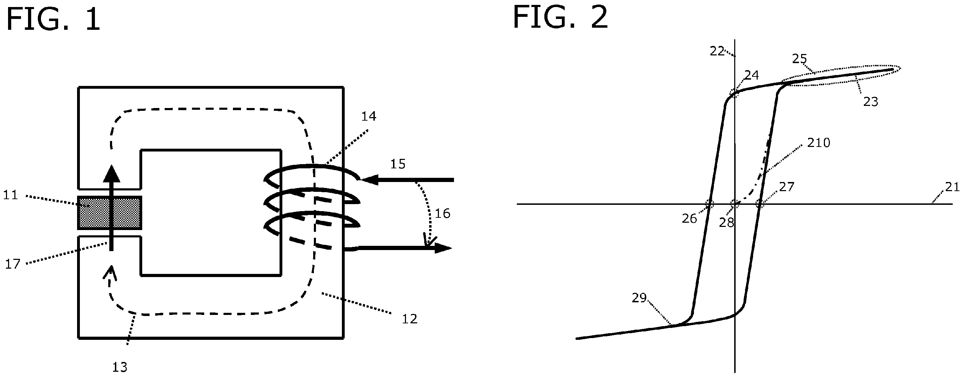

Eine Einrichtung zur Bestimmung der magnetischen Materialeigenschaften ist in Fig. 1 als Prinzipschema dargestellt. Die Kennlinien für Durchflutung und Fluss werden in einem geschlossenen magnetischen Kreis ermittelt und stellen die sogenannte Hysteresekurve dar. Die zu prüfende Materialprobe 11 wird dabei einer variablen magnetischen Durchflutung ausgesetzt, und die entstehende magnetische Flussdichte wird beim Ein- und Austritt aus der Materialprobe 11 in einer Ebene normal zur Richtung der Durchflutung gemessen. Die Normale zu dieser Ebene dient als Bezugsrichtung 17 für das Vorzeichen der ermittelten Werte für Feldstärke und Flussdichte. Der magnetische Kreis wird durch ein Joch 12 aus magnetisch leitfähigem Material geschlossen. Die Spule 14 erzeugt im Joch 12 einen magnetischen Fluss 13, der die Materialprobe 11 durchdringt. Erzeugt wird dieser Fluss durch den die Spule 14 durchfliessenden Strom 15. An Hand dieses Stromes 15 und der an der Spule entstehenden Spannung 16 lassen sich die magnetischen Eigenschaften der Materialprobe 11 ermitteln und beschreiben.

Zum Ermitteln der Hysteresekurve wird in der Vorrichtung gemäss Fig. 1 ein Strom 15 wechselweise in beiden Polaritäten durch die Spule 14 geleitet. Der durch die Materialprobe 11 fliessende Magnetfluss wird auf bekannte Weise durch Aufnahme des Spannungs-Zeitintegrales an einer hier nicht dargestellten Prüfspule ermittelt, welche die Materialprobe umgibt.

Magnetische Durchflutung und Magnetfluss werden, jeweils bezogen auf die Dimensionen der Materialprobe, als magnetische Feldstärke und Flussdichte im Diagramm gemäss Fig. 2 dargestellt. Das Diagramm stellt auf der horizontalen Achse 21 die magnetische Feldstärke H in und auf der vertikalen Achse 22 die magnetische Flussdichte B dar. Auf beiden Achsen liegt der Nullpunkt an ihrem Schnittpunkt 28 Positive und negative Werte werden darauf bezogen, wobei sich das Vorzeichen auf die durch den magnetischen Kreis vorgegebene Richtung 17 bezieht.

Der entsprechende Verlauf wird als Hysteresekurve bezeichnet. Dabei sind die folgenden Punkte bzw. Abschnitte kennzeichnend. Punkt 28 kennzeichnet den vollständig unmagnetisierten Zustand. Die Lage des Remanenzpunktes 24, bei magnetischer Feldstärke null, gibt die Remanenzflussdichte Br an. Die Zone 25 entspricht dem Zustand der magnetischen Sättigung. Der Koerzitivpunkt 26 stellt die magnetische Feldstärke dar, bei der die Flussdichte null beträgt. Dieser Punkt gibt die Koerzitivfeldstärke Hc an. Die Zone 29 bzw. der Punkt 27 auf dem Kennlinienabschnitt, der sich auf die umgekehrte Richtung von magnetischer Feldstärke bzw. Flussdichte bezieht, entsprechen im absoluten Wert dem Remanenzpunkt 24 bzw. dem Koerzitivpunkt 26. Die experimentell ermittelten Hysteresekurven sind grundsätzlich symmetrisch, das heisst die ermittelten Werte sind in beiden Richtungen identisch.

Die Hysteresekurve stellt die Grenzlinie der Zustände dar, welche das Material im betreffenden Körper einnehmen kann. Sie umhüllt den Bereich der anhysteretischen Zustände, der beim Entmagnetisieren durchfahren wird. Je nach vorgängigem Verlauf von Durchflutung und Flussdichte kann das Material irgendeinen Zustand innerhalb der Hysteresekurve einnehmen. Dies zeigt sich am Beispiel der Neukurve 210, welche vom vollständig unmagnetisierten Zustand 28 zur Hysteresekurve überleitet. Das Material durchfährt diese Neukurve 210 beim erstmaligen Aufmagnetisieren aus dem vollständig entmagnetisierten Zustand.

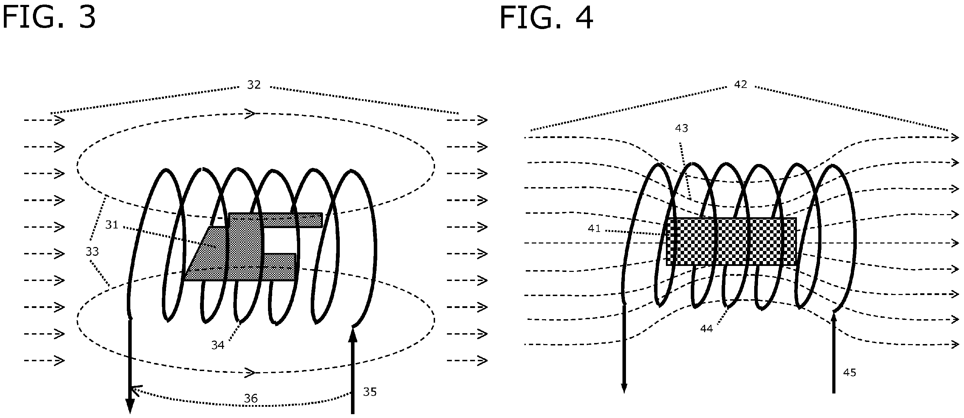

Wird ein ferromagnetischer Körper einem umgebenden Magnetfeld ausgesetzt, entsteht eine gegenseitige Beeinflussung wie in Fig. 4 gezeigt. Der Körper 31 verfügt über eine bessere Leitfähigkeit für den magnetischen Fluss als die Umgebung. Seine Permeabilität ist höher. Er sammelt den magnetischen Fluss 32 in seiner Umgebung, konzentriert diesen in seinem Material, und gibt ihn wieder an die Umgebung ab. Dies führt zu einer Verzerrung des umgebenden Feldes und gleichzeitig zu einer Magnetisierung des Körpers selbst. Mit dieser wechselseitigen Beeinflussung entsteht an den Extremitäten des Körpers eine erhöhte magnetische Flussdichte. Diese Erscheinung wird als induzierten Magnetismus bezeichnet. An den betreffenden Extremitäten entstehen induzierte magnetische Pole.

Im Bericht "Comparison of Stepwise Demagnetization Techniques" von T.M. Baynes, G.J. Russell und A. Bailey, publiziert in den IEEE Transactions on Magnetics, Vol. 38, No. 4, July 2002, Seiten 1753 ff. wird in Fig. 4 beispielhaft eine Neukurve "initial curve" und eine Kommutierungskurve "anhysteretic (curve)" gezeigt. Dem Bericht liegen experimentelle Versuche zum Entmagnetisieren von Schiffen zu Grunde, die im reduzierten Massstab durchgeführt wurden. Dabei wurde ein Stahlrohr von 300mm Länge und 32mm Aussendurchmesser mit einer koaxial umfassenden Spule entmagnetisiert. Ein entsprechender Aufbau ist schematisch in Fig. 3 dargestellt. Er entspricht gängiger Technik, wie sie zum Entmagnetisieren von Bauteilen, Baugruppen und ganzen Maschinen aus ferromagnetischem Material eingesetzt wird. Das zu entmagnetisierende Objekt 31 wird im Inneren einer Spule 34 untergebracht, welche ein entmagnetisierendes Magnetfeld 33 mit wechselweiser Polarität und abnehmender Amplitude erzeugt. Die dafür notwendige Spulenspannung 36 und der Spulenstrom 35 werden von einer nicht in der Fig. 3 enthaltenen Stromquelle mit programmierbarer Amplitude und Frequenz geliefert. Ein in der Umgebung vorhandenes Magnetfeld 32, in der Darstellung Fig. 3 koaxial zur Spulenachse ausgerichtet, ist in der Realität beliebig von beliebiger Richtung. Es handelt sich beispielsweise um das überall und stets auftretende Erdmagnetfeld. Dieses, dem entmagnetisierenden Feld 33 überlagerte Magnetfeld, wird in technischen Anwendungen nicht berücksichtigt. Die gezeigte Vorrichtung genügt in vielen Fällen den Ansprüchen, bringt aber, wie Versuche gezeigt haben, kein vollständiges Verschwinden des Restmagnetismus im Objekt 31.

Im zitierten Experiment von Baynes et al. wurde nun zusätzlich und gleichzeitig ein quer zur Richtung des Rohrs stehendes Magnetfeld angelegt, dies mit zwei rechteckigen, beidseits des Rohrs und ausserhalb der Entmagnetisierspule angeordneten Helmholtzspulen. Das angestrebte Ziel, mit dem Zusammenwirken beider Spulen das umgebende Erdfeld während dem Entmagnetisiervorgang zu kompensieren, wurde nur unvollkommen erreicht. Ein vollständiges Entmagnetisieren des Stahlrohrs gelang nicht. Der in dieser Literaturstelle beschriebene Entmagnetisierprozess ist auf die Anwendung an Schiffen zugeschnitten, bei denen gleichzeitig ein bestimmter Restmagnetismus einzuprägen ist, der dem vom Erdfeld im Schiffskörper induzierten Magnetismus entgegenwirkt. Die das Rohr umgebenden Helmholtzspulen sind deshalb mit einem Gleichstrom beaufschlagt, der diesen Restmagnetismus erzeugt. Der Zweck, und damit auch das verfahrenstechnische Vorgehen entsprechen nicht dem Ziel eines möglichst vollständigen Beseitigens von Restmagnetismus. Als wissenschaftliches Ergebnis zeigt sich, dass die Anzahl der Schritte mit wechselnder Polarität und abnehmender Amplitude bis mindestens zur Anzahl 80 einen direkten Einfluss auf den Restmagnetismus hat

Auch eine schaltungstechnische Verfeinerung einer solchen Vorrichtung bringt kein vollständiges Verschwinden von Restmagnetismus, wie aus dem Bericht "Demagnetization of magnetically shielded rooms" von F. Thiel, A. Schnabel, S. Knappe-Grüneberg, D. Stollfuss, und M. Burghoff, publiziert in Review of Scientific Instruments 78, 035106 (2007) hervorgeht. Dabei wird ein verbesserter Entmagnetisierprozess für hochpermeable Abschirmbleche beschrieben, der an Hand von Experimenten entwickelt wurde. Die dabei eingesetzten schaltungstechnischen Massnahmen sind
- Der Ersatz des üblicherweise eingesetzten Regeltrafos mit Netzfrequenz-Speisung durch einen elektronischen Leistungsverstärker als Stromquelle.
- Ein Trenntrafo zur Speisung der Entmagnetisierspule, der den unvermeidlichen Gleichstromanteil (Drift und Offset) am Ausgang des Leistungsverstärkers von der Entmagnetisierspule fernhält.
- Die Ansteuerung dieses Verstärkers durch einen A/D-Wandler hoher Auflösung, seinerseits digital angesteuert mit einem Programm, das eine freie Wahl von Spannungsform, Frequenz und Amplitude gestattet.
- Weitere Schaltungselemente wie Filter und Abschwächer zur Optimierung und Anpassung des Signals.

Die Ergebnisse des vorgenannten Entmagnetisierprozesses sind auf industrielle Anwendungen nicht übertragbar:
- Das im Experiment als zu entmagnetisierendes Objekt eingesetzte hochpermeable Material (Mu-Metall) kommt in industriellen Anwendungen ausgesprochen selten vor und ist mit den typisch als Objekt vorkommenden Materialien, Teilen und Baugruppen nicht vergleichbar.
- Die im Experiment eingesetzten Mittel sind zum Entmagnetisieren von Komponenten aus industrieüblichen ferromagnetischen Materialien nicht geeignet, weil sie die notwendige Feldstärke dazu nicht aufbringen.
- Die im Experiment eingesetzten Sensoren für das Magnetfeld sind extrem empfindlich, die angestrebten Werte für das Restmagnetfeld extrem tief. Die Messungen erfolgten aber, gegeben unter anderem durch die in ihren Dimensionen zu grossen Sensoren, in vergleichsweise grosser Distanz zur Metalloberfläche. Das in der industriellen Anwendung entscheidende magnetische Restfeld unmittelbar an der Oberfläche des Materials wurde nicht ermittelt.
- Das bei der Auswertung abschliessend eingesetzte Kriterium eines Spektrums von 1 bis 100 Hz für das magnetische Restrauschen steht in keinem Zusammenhang mit dem Restmagnetismus von technischen Teilen, der in Produktionsprozessen störend ist.

Die Bestimmung des Materialverhaltens im anhysteretischen Bereich wird benutzt zur Charakterisierung von Gesteinsproben mit ferromagnetischem Verhalten an Hand des sogenannten Paläomagnetismus. Hierzu wird beispielsweise das Gerät D-2000 von der Firma ASC Scientific, Carlsbad, California, eingesetzt. Das messtechnische Vorgehen ist beschrieben in http://magician.ucsd.edu/Essentials_2/WebBook2ch9.html#x11-10800210. Die Gesteinsprobe wird entweder mit einem einmaligen Stromimpuls durch eine umgebende Spule entlang der Hysteresekurve aufmagnetisiert, oder durch zyklische, wechselweise gerichtete Stromimpulse auf einen Zustand im anhysteretischen Bereich gebracht. Der im Anschluss an diese Behandlung gemessene Restmagnetismus dient zur Charakterisierung der Gesteinsprobe. Auch wenn der Begriff Entmagnetisieren benützt wird, besteht die Methode der Behandlung im Einbringen von Magnetismus. Die zur Behandlung der Gesteinsproben eingesetzten Hilfsmittel dienen demnach nicht zur Beseitigung, sondern zur Erzeugung von Magnetismus. EP1693833 A1 offenbart eine Kammer mit Wänden zur Abschirmung von elektromagnetischen Feldern, wobei die Kammer einen Kammerinnenraum aufweist, in welchen eine Entmagnetisierspule aufnehmbar ist. Die Kammer ist aus Eisen und im Betrieb, vollständig geschlossen.

Die vorliegende Erfindung setzt nun bei den theoretischen Modellen an, welche in den vorzitierten wissenschaftlichen Berichten zu finden sind. Sie betrifft ein Verfahren zum Entmagnetisieren von ferromagnetischen Teilen in jenem Bereich von Restmagnetismus, der in der Grössenordnung des Erdfeldes und darunter liegt und gemäss dem Stand der Technik nur durch thermisches Entmagnetisieren erreichbar ist.

### Darstellung der Erfindung

Die vorliegende Erfindung ist in Anspruch 1 definiert und stellt sich zur Aufgabe, die Entmagnetisierung von ferromagnetischen Bauteilen mittels einfacher Erweiterungen einer Entmagnetisiervorrichtung zu verbessern. Es werden trotz Entmagnetisierung bei etwa Raumtemperatur ferromagnetische Bauteile mit derart geringem Restmagnetismus erreicht, was bislang nur durch thermisches Entmagnetisieren erreichbar war.

### Kurze Beschreibung der Zeichnungen

Ein bevorzugtes Ausführungsbeispiel des Erfindungsgegenstandes wird nachstehend im Zusammenhang mit den anliegenden Zeichnungen beschrieben.
- Figur 1: zeigt schematisch eine aus dem Stand der Technik bekannte Messeinrichtung der Hystereseschlaufe.
- Figur 2: zeigt als Beispiel eine magnetische Zustandskennlinie (Hysteresekurve)
- Figur 3: zeigt eine aus dem Stand der Technik bekannte Entmagnetisiervorrichtung mit Luftspule in einer schematischen Ansicht.
- Figur 4: zeigt schematisch den Einfluss eines umgebenden Magnetfeldes auf eine Entmagnetisiervorrichtung bekannter Art.
- Figur 5: zeigt schematisch die Wirkung einer magnetischen Abschirmung des umgebenden Magnetfeldes.
- Figur 6: zeigt die erfindungsgemässen Merkmale einer Abschirmung des umgebenden Magnetfeldes im Zusammenwirken mit einer Entmagnetisierspule in einer schematischen Ansicht.
- Figur 7: zeigt eine perspektivische Ansicht einer Kammer mit Entmagnetisierspule.

### Beschreibung

Der in einem geometrisch begrenzten Körper aus ferromagnetischem Material bestehende Magnetismus ist in der Regel nicht gleichmässig verteilt. Durch die Wechselwirkung zwischen dem magnetisierten Körper und seiner Umgebung ergeben sich Unterschiede in der Flussdichte, die an der Oberfläche des Körpers punktuell zum Vorschein kommen. Solche Unterschiede entstehen beispielsweise durch die Gestalt des Körpers selbst, aber auch durch allfällig im Körper vorhandene Inhomogenitäten des Materials.

Zum Entmagnetisieren wird der Körper in einer ersten Phase durch das von aussen aufgebrachte entmagnetisierende Magnetfeld in die Sättigung getrieben. Dabei durchlaufen alle Partien des Körpers die Hysteresekurve bis in den Bereich der Sättigung. Bestehende Unterschiede in verschiedenen Partien des Körpers werden damit ausgeglichen, und die Richtung des Magnetismus im Inneren des Körpers wird ausgerichtet. Der so erzeugte Materialzustand ist nicht mehr von der Vorgeschichte bestimmt, sondern einwandfrei reproduzierbar. Die Entmagnetisierspule muss in Verbindung mit ihrer Speisung in der Lage sein, diesen Sättigungszustand überall im zu entmagnetisierenden Körper zu erzeugen. Bei den industriell eingesetzten Geräten und Anlagen ist dies in der Regel, aber durchaus nicht immer, erfüllt.

In einer zweiten Phase wird die Amplitude des in wechselnder Richtung wirkenden Stromes in der Entmagnetisierspule allmählich vermindert. Mit dem mehrfachen Durchlaufen verkleinert sich die Hystereseschlaufe des Gesamtkörpers. Erklärt wird dieser Effekt durch das Aufteilen der magnetischen Domänen im Material in immer kleinere Einheiten, die sich in ihrer Ausrichtung unabhängig verhalten. Entscheidend für die Wirkung ist ein genügend kleines Dekrement in der Amplitude des Spulenstromes. Wissenschaftliche Publikationen wie auch betriebliche Erfahrungen verlangen ein Dekrement von höchstens 1...2% pro Periode. Dies ist bei einem grossen Teil der praktisch eingesetzten Geräte und Anlagen nicht erfüllt. So zeigen frei ausschwingende Schwingkreisschaltungen infolge des Widerstandes des Kupferleiters der Spule ein deutlich grösseres Dekrement und ergeben kein reproduzierbares Ergebnis beim Entmagnetisieren. Manuell betriebene Schaltungen, bei denen der Spulenstrom Impuls für Impuls einzeln in der Stärke eingestellt und ausgelöst wird, gewährleisten kein verlässliches Ergebnis. Das genannte Dekrement erfordert eine automatische Steuerung des Ablaufes und das Zuführen von elektrischer Energie während dem Abbau der Stromamplitude. Anlagen dieser Art sind Stand der Technik, unter anderem beschrieben in der Patentschrift EP 1 465 217.

Die Entmagnetisierspule kann aber auch ohne Schwingkreis allein durch geeignete externe Speisung mit programmierter Frequenz und Spannung beaufschlagt werden, wie beschrieben in der Patentschrift EP 179 1138.

Wenn diese zweite Phase zu Ende geht, die Amplitude des Spulenstromes gegen Null strebt und der Stromfluss schlussendlich abgebrochen wird, zeigen sich einige störende Effekte mit deutlichem Einfluss auf den verbleibenden Restmagnetismus. Es sind dies:
a) Die externe Energiezufuhr zum Schwingkreis wird beim Erreichen einer vorgegebenen Zeitdauer automatisch abgebrochen. Ein verbleibender, bestimmter Grad von Magnetismus im Objekt muss dabei in Kauf genommen werden, gegeben durch die letzte durchlaufende Hystereseschlaufe im anhysteretischen Bereich.
b) Die externe Energiezufuhr zum Schwingkreis wird abgebrochen, weil die Istwerterfassung für Strom und/oder Spannung und damit der dafür zuständige Regelkreis an die Grenze ihrer Auflösung stösst. Dies bestimmt, analog zum Fall a), eine Grenze für die technisch mögliche Entmagnetisierung mit der betreffenden Einrichtung.
c) Die externe Energiezufuhr erzeugt in Strom bzw. Spannung der Spule eine Gleichstromkomponente. Diese führt zu einer Unsymmetrie der durchlaufenen Hystereseschlaufe und erzeugt so zwangsläufig einen Restmagnetismus.
d) Ein während dem Entmagnetisierungsvorgang im Raum der Spule wirksames Magnetfeld aus anderer Quelle führt analog zum Fall c) zu einer Unsymmetrie der durchlaufenen Hystereseschlaufe und erzeugt einen Restmagnetismus. Beispiel dazu ist das Magnetfeld der Erde.

Unter Ausschöpfung schaltungstechnischer Mittel gelingt es, die unter a) bis c) genannten Effekte soweit zu beherrschen, dass der Restmagnetismus unter einen Wert kommt, der sich allein unter dem Einfluss des Erdfeldes als induzierter Magnetismus ergibt. Die vorliegende Erfindung ermöglicht es nun, auch diese Grenze zu unterschreiten.

Die im Folgenden formulierte Beschreibung bezieht sich auf zu entmagnetisierende Objekte 51, 61 in Form von ferromagnetischen Körpern von Dimensionen, wie sie im allgemeinen Maschinenbau, im Stahlbau, im Werkzeugbau und in mikromechanischen Komponenten vorkommen. Unter den Begriff der ferromagnetischen Materialien werden im Folgenden auch hochpermeable sowie dauermagnetische Werkstoffe verstanden. Die Materialien können amorph oder kristallin sein und sowohl als metallische Legierung als auch in keramischer Form vorliegen.

Die betreffenden Körper können einzeln oder in einer Vielzahl, geordnet oder ungeordnet, ausgerichtet oder in beliebiger Richtung, in einem Gebinde oder verbunden zu einem Konglomerat, auf Transportträgern fixiert oder als loses Schüttgut vorliegen. Die betreffenden Körper können von beliebiger Gestalt, auch zusammengesetzt aus mehreren Teilen sein. Das Material des Körpers kann homogen sein oder abschnittsweise unterschiedliche Eigenschaften aufweisen, wobei zumindest ein Abschnitt ferromagnetische Eigenschaften aufweist.

Die Darstellungen zeigen die Verteilung des Magnetflusses unter analogen Bedingungen in einem realen Körper.

Eine mögliche Entmagnetisiervorrichtung umfasst mindestens eine
- Entmagnetisierspule 54, 65 als Luftspule, ausschliesslich bestehend aus nicht-ferromagnetischen Materialien, wobei die Entmagnetisierspule 54, 65 das zu entmagnetisierende Objekt 51, 61 in allen seinen Dimensionen vollständig umfasst.
- Stromquelle für die Luftspule 54, 65, einen Entmagnetisierpuls bekannten Verlaufes liefernd und eine Gleichstromkomponente mit schaltungstechnischen Mitteln ausschliessend.
- Abschirmung passiv, als Kammer aus hochpermeablem Material, in verschiedenen Konfigurationen. Ein die Kammer umgebendes Störfeld 52 verläuft als umgebendes Magnetfeld 53 innerhalb der Wände der Kammer.

### Merkmale des Verfahrens

Zuerst wird das zu entmagnetisierende Objekt 51, 61 in den Innenraum der Entmagnetisierspule 54, 65, welche sich in der Kammer befindet, eingebracht. Durch die passive Abschirmwirkung der Kammer aus hochpermeablem Material ist der Kammerinnenraum von äusseren Störfeldern frei bzw. nahezu frei. Das als Störfeld wirkende Erdmagnetfeld wird durch die passive Abschirmung innerhalb der Kammer deutlich verringert und im Idealfall auf Null reduziert bzw. durch die hochpermeablen Kammerwände aus dem Kammerinnenraum verdrängt. Die Störfeldstärke innerhalb der Kammer wird dadurch mindestens auf etwa die Hälfte oder weniger der Feldstärke in einer ungeschirmten Kammer verringert.

Die eigentliche Entmagnetisierung wird durch Anlegen eines abklingenden magnetischen Wechselfeldes als Entmagnetisierfeld innerhalb der Entmagnetisierspule, entlang einer vorgegebenen Entmagnetisierkurve durchgeführt. Dabei wird bevorzugt eine Steuerung und der Ablauf der Entmagnetisierkurve, wie aus der EP 179 1138 des Anmelders bekannt, verwendet.

Das resultierende Entmagnetisierfeld in der Entmagnetisierspule weist einen alternierenden zeitlichen Verlauf auf, wobei die Amplitude in einer bestimmten Anzahl von Perioden gegen Null abnimmt. Damit keine Restmagnetfelder eingeprägt werden, ist unbedingt eine Gleichstromkomponente des Spulenstromes während des Durchlaufens der Entmagnetisierkurve zu vermeiden.

Während des Entmagnetiservorganges ist die Einstreuung extern bestehender bzw. erzeugter Magnetfelder, Störfelder, auf das zu entmagnetisierende Objekt durch die Abschirmung. nahezu vollständig unterdrückt.

### Kammergestaltung

Die Wände der Kammer sind aus einer oder einer Mehrzahl von Lagen eines oder verschiedener hochpermeabler Materialien hergestellt, womit Fremdmagnetfelder jeglicher Art am zu entmagnetisierenden Objekt im Kammerinnenraum während des Entmagnetisierens ferngehalten werden. Die Lage bzw. die Lagen der Wände bestehen aus Magnetfeld leitendem Material.

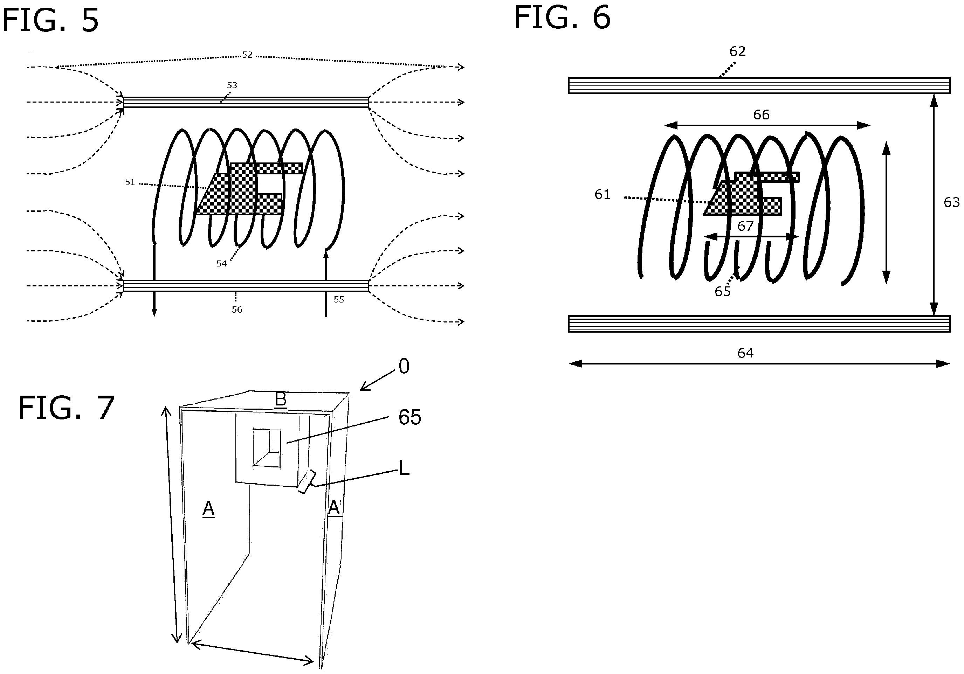

Wie in Figur 6 schematisch gezeigt befindet sich die Entmagnetisierspule 65 innerhalb der Kammer, wobei die Innenabmessungen 63, beispielsweise der Abstand der Seitenfläche 63 zueinander, entsprechend die Dimensionen der Entmagnetisierspule gestaltet sind. Die Entmagnetisierspule 65 ist derart ausgestaltet und positioniert, dass die Kammerwände die Entmagnetisierspule 65 in allen Richtungen überlappen. Die zu entmagnetisierenden Objekte 61 müssen derartige Längen 67 aufweisen, dass diese vollständig von der Entmagnetisierspule 65 umschlossen werden.

In Figur 7 ist eine spezielle Gestaltung der Kammer 0 dargestellt. Zwei Seitenwände A, A' sind im Abstand a über eine Deckwand B miteinander verbunden, womit eine U-Profilartige bzw. haubenartige Kammer 0 mit drei Wänden erreicht wird. Eine derartig gestaltete Kammer 0 kann mit geringem Montageaufwand auf einer bestehenden Entmagnetisiervorrichtung montiert werden. Hier sind die Seitenflächen A, A' doppelt so lang wie die Deckwand B ausgestaltet, wodurch eine Flusssammlung erreicht und der Einfluss von Störfeldern minimiert wird.

Die Kammer ist derart ausgestaltet, dass sie mindestens drei bis maximal sechs Seitenwänden aufweist und damit vollständig geschlossen ausgestaltet wäre. Die im Kammerinnenraum positionierte Entmagnetisierspule 65 wäre damit entweder von aussen von einer oder zwei Seiten frei oder nach Öffnung einer Seitenwand von einer Seite zugänglich. Die im Kammerinnenraum positionierte Entmagnetisierspule ist von aussen von einer oder zwei Seiten frei, ohne Öffnung einer Seitenwand, zugänglich. Durch eine öffenbar oder zerlegbar gestaltete Kammer kann die Entmagnetisierspule 65 zur Einführung von Objekten 61 aber auch für Instandhaltungs- bzw. Instandsetzungsvorgänge einfach zugänglich sein.

Zur Erreichung guter Entmagnetisierergebnisse sollten die Wände, länger als die Spulenlänge L ausgeführt sein, sodass die Wände die Spule 65 überlappen. Es hat sich als vorteilhaft herausgestellt, dass diese Überlappung mindestens der Hälfte der Spulenlänge L entspricht.

Optional zur Abschirmung des zu entmagnetisierenden Objektes 51, 61 innerhalb der Kammer, kann mindestens eine Lage der Kammerwände aus einem gut elektrisch leitfähigem Material, insbesondere aus Kupfer, Silber oder Aluminium ausgestaltet sein. In dieser mindestens einen Lage werden Wirbelströme aufgebaut, welche den Kammerinnenraum gegen magnetische Wechselfelder abschirmen, womit der Restmagnetismus im zu entmagnetisierenden Objekt 51, 61 weiter verringerbar ist.

### Bezugszeichenliste

- 0: Kammer
- 11: Materialprobe
- 12: Magnetisch leitfähiges Joch
- 13: Pfad des magnetischen Flusses
- 14: Spule
- 15, 35, 45, 55: Spulenstrom
- 16: Spulenspannung
- 17: Bezugsrichtung für das Magnetfeld
- 21: X-Achse, magnetische Feldstärke H [A/m]
- 22: Y-Achse, magnetische Flussdichte B [Vs/m2]
- 23: magnetisch gesättigte Zone
- 24: Hysteresekurve im Bereich der magnetischen Sättigung
- 25: Bereich der magnetischen Sättigung
- 26: Koerzitivfeldstärke
- 27: Koerzitivfeldstärke (umgekehrte Richtung)
- 28: Zustand vollständiger Entmagnetisierung
- 29: Hysteresekurve (umgekehrte Richtung)
- 210: Neukurve
- 31, 41, 51, 61: Zu entmagnetisierendes Objekt
- 32: Umgebendes Magnetfeld
- 33: Entmagnetisierendes Magnetfeld
- 34, 44, 54: Entmagnetisierspule
- 36: Spulenspannung
- 42: Umgebendes, ungestörtes Magnetfeld
- 43: Umgebendes, verzerrtes Magnetfeld
- 52: Umgebendes, ungestörtes Magnetfeld
- 53: Umgebendes Magnetfeld in der Abschirmung
- 56: Abschirmung
- 62: Abschirmung
- 63: Innenabmessung der Abschirmung normal zur Achse der Entmagnetisierspule
- 64: Länge der Abschirmung parallel zur Achse der Entmagnetisierspule
- 65: Entmagnetisierspule
- 66: Länge der Entmagnetisierspule
- 67: Länge des zu entmagnetisierenden Objektes
- A, A': Seitenwände
- a: Abstand
- B: Deckwand
- L: Spulenlänge

## Patentansprüche

1. Verwendung einer Kammer (0) mit Wänden zur Abschirmung einer Entmagnetisierspule (34, 44, 54, 65), wobei die Kammer (0) einen Kammerinnenraum aufweist, in welchem die Entmagnetisierspule (34, 44, 54, 65) aufnehmbar ist, während in der Entmagnetisierspule (34, 44, 54, 65) innerhalb des Kammerinnenraumes eine Entmagnetisierung eines ferromagnetischen Bauteils (31, 41, 51, 61) durch Anlegen eines abklingenden magnetischen Wechselfeldes und Beaufschlagung mit einem Spulenstrom (15, 35, 45, 55) entlang einer vorgegebenen Entmagnetisierkurve abläuft, wobei die Entmagnetisierspule (54, 65) das zu entmagnetisierende Bauteil (51, 61) in allen seinen Dimensionen vollständig umfasst, wobei die Kammer derart ausgestaltet ist, dass sie mindestens drei bis maximal sechs Seitenwände aufweist und damit vollständig geschlossen ausgestaltet wäre, sodass die im Kammerinnenraum positionierte Entmagnetisierspule (65) damit entweder von aussen von einer oder zwei Seiten frei oder nach Öffnung einer Seitenwand von einer Seite zugänglich wäre, wobei die im Kammerinnenraum positionierte Entmagnetisierspule (65) von aussen von einer oder zwei Seiten frei, ohne Öffnung einer Seitenwand, zugänglich ist, wobei die Wände mindestens eine Lage magnetisch hochpermeablen ferromagnetischen Materials aufweisen, zur Abschirmung von in den Kammerinnenraum einwirkenden äusseren Störfeldern, umfassend das Erdmagnetfeld , zur Erreichung einer Reduktion der Störfeldstärke im Kammerinnenraum auf weniger als die Hälfte der Störfeldstärke ausserhalb des Kammerinnenraumes am jeweiligen Ort der Kammer (0).

2. Verwendung einer Kammer während der Entmagnetisierung gemäss Anspruch 1, wobei die Wände der Kammer mindestens eine Lage aus einem gut elektrisch leitendem Material, insbesondere aus Kupfer, Silber oder Aluminium aufweisen.

3. Verwendung einer Kammer während der Entmagnetisierung gemäss einem der vorhergehenden Ansprüche, wobei die Entmagnetisierspule fest mit der Kammer, im Kammerinnenraum angeordnet ist.

4. Verwendung einer Kammer während der Entmagnetisierung gemäss einem der vorhergehenden Ansprüche, wobei die Ausdehnungen der Wände die Ausdehnung der Entmagnetisierspule überragen, sodass die Wände der Kammer die Entmagnetisierspule überlappen.

5. Verwendung einer Kammer während der Entmagnetisierung gemäss Anspruch 4, wobei die Wände die Länge der Entmagnetisierspule überragen.

6. Verwendung einer Kammer während der Entmagnetisierung gemäss einem der vorhergehenden Ansprüche, wobei die Kammer die Form eines U-Profils aufweist, umfassend zwei Seitenwände verbunden über eine Deckwand.

## Claims

1. The use of a chamber (0) with walls for shielding a demagnetizing coil (34, 44, 54, 65), wherein the chamber (0) has a chamber interior, in which the demagnetizing coil (34, 44, 54, 65) can be accommodated, whilst a demagnetization of a ferromagnetic component (31, 41, 51, 61) proceeds along a predetermined demagnetization curve in the demagnetizing coil (34, 44, 54, 65) within the chamber interior by applying an attenuating magnetic alternating field and loading with a coil current (15, 35, 45, 55), the demagnetizing coil (54, 65) surrounding the component (51, 61) to be demagnetized completely in all of the dimensions thereof, the chamber being designed in such a manner that it has at least three to at most six side walls and thus would be designed in a completely closed manner, so that the demagnetizing coil (65) positioned in the chamber interior is therefore accessible either from the outside freely from one or two sides or from one side after opening a side wall,
the demagnetizing coil (65) positioned in the chamber interior being accessible from the outside freely from one or two sides without opening a side wall, the walls having at least one layer of highly magnetically permeable ferromagnetic material, for shielding from external interference fields acting in the chamber interior,
including the Earth's magnetic field, to achieve a reduction of the interference-field strength in the chamber interior to less than half of the interference field strength outside of the chamber interior at the respective location of the chamber (0).

2. The use of a chamber during the demagnetization according to Claim 1, wherein the walls of the chamber have at least one layer made from a material that conducts electricity well, particularly from copper, silver or aluminium.

3. The use of a chamber during the demagnetization according to one of the preceding claims, wherein the demagnetizing coil is arranged in the chamber interior, fixed to the chamber.

4. The use of a chamber during the demagnetization according to one of the preceding claims, wherein the extents of the walls project beyond the extent of the demagnetizing coil, so that the walls of the chamber overlap the demagnetizing coil.

5. The use of a chamber during the demagnetization according to Claim 4, wherein the walls project beyond the length of the demagnetizing coil.

6. The use of a chamber during the demagnetization according to one of the preceding claims, wherein the chamber has the shape of a U-profile, comprising two side walls connected via a cover wall.

## Revendications

1. Utilisation d'une chambre (0) avec des parois pour le blindage de protection d'une bobine de démagnétisation (34,44,54,65), la chambre (0) comportant un espace intérieur de chambre dans lequel la bobine de démagnétisation (34,44,54,65) peut être logée, pendant que se déroule une démagnétisation d'un composant ferromagnétique (31,41,51,61) dans la bobine de démagnétisation (34,44,54,65) à l'intérieur de l'espace intérieur de chambre par application d'un champ alternatif magnétique décroissant et sollicitation avec un courant de bobine (15,35,45,55) le long d'une courbe de démagnétisation préalablement fixée, la bobine de démagnétisation (54,65) englobant entièrement dans toutes ses dimensions le composant à démagnétiser (51,61), la chambre étant constituée de telle sorte qu'elle comporte au moins trois à six parois latérales maximum et serait de ce fait entièrement fermée de telle sorte que la bobine de démagnétisation (65) positionnée dans l'espace intérieur de chambre soit librement accessible, soit de l'extérieur d'un ou de deux côtés, soit d'un côté après ouverture d'une paroi latérale, la bobine de démagnétisation (65) positionnée dans l'espace intérieur de chambre étant accessible librement de l'extérieur d'une ou de deux côtés, sans ouverture d'une paroi latérale, les parois comportant au moins une couche de matériau ferromagnétique hautement perméable du point de vue magnétique pour le blindage de protection envers des champs parasites extérieurs agissant dans l'espace intérieur de chambre comprenant le champ magnétique terrestre, pour obtenir une réduction de l'intensité de champ parasite dans l'espace intérieur de chambre sur moins de la moitié de l'intensité du champ parasite en dehors de l'espace intérieur de chambre à l'endroit concerné de la chambre (0) .

2. Utilisation d'une chambre pendant la démagnétisation selon la revendication 1, les parois de la chambre comportant au moins une couche d'un matériau bon électro-conducteur, notamment en cuivre, argent ou aluminium.

3. Utilisation d'une chambre pendant la démagnétisation selon l'une quelconque des revendications précédentes, la bobine de démagnétisation étant disposée fixement avec la chambre dans l'espace intérieur de chambre.

4. Utilisation d'une chambre pendant la démagnétisation selon l'une quelconque des revendications précédentes, les extensions des parois dépassant l'extension de la bobine de démagnétisation de telle sorte que les parois de la chambre recouvrent la bobine de démagnétisation.

5. Utilisation d'une chambre pendant la démagnétisation selon la revendication 4, les parois dépassant la longueur de la bobine de démagnétisation.

6. Utilisation d'une chambre pendant la démagnétisation selon l'une quelconque des revendications précédentes, la chambre comportant la forme d'un profilé en U, comprenant deux parois latérales reliées par une paroi de couverture.
